# FASCICULE DE BREVET EUROPEEN

(11) **EP 2 432 586 B1**
(45) Date de publication et mention de la délivrance du brevet: **16.03.2016**
(21) Numéro de dépôt: 10728751.8
(22) Date de dépôt: 12.05.2010
(51) Int. Cl.: H01L 21/311, H01L 21/3213

(54) **PROCEDE DE GRAVURE D'UN MATERIAU EN PRESENCE D'UN GAZ**
VERFAHREN ZUM ÄTZEN EINES MATERIALS IN GEGENWART EINES GASES
METHOD FOR ETCHING A MATERIAL IN THE PRESENCE OF A GAS

(30) Priorité: 18.05.2009 FR 0953293
(43) Date de publication de la demande: 28.03.2012
(73) Titulaire: Institut Polytechnique de Grenoble, 38031 Grenoble Cedex (FR); Université Joseph Fourier, 38400 Saint-Martin-d'Hères (FR)
(72) Inventeur: BAILLET, Francis, F-38850 Paladru (FR); GONDREXON, Nicolas, F-38240 Meylan (FR)
(74) Mandataire: Casalonga, Axel
(86) Numéro de dépôt international: PCT/FR2010/050927
(87) Numéro de publication internationale: WO 2010/133786

(56) Documents cités:
- EP-A2- 0 844 650
- FR-A- 2 923 947
- US-A1- 2004 226 654
- CHEN J ET AL: "Study of anisotropic etching of (1 0 0) Si with ultrasonic agitation" SENSORS AND ACTUATORS A, ELSEVIER SEQUOIA S.A., LAUSANNE, CH, vol. 96, no. 2-3, 28 février 2002 (2002-02-28), pages 152-156, XP004343623 ISSN: 0924-4247

## Description

La présente invention concerne le domaine de la gravure d'un matériau.

La présente invention peut concerner plus particulièrement le domaine de la fabrication des composants semiconducteurs, dans lequel il est généralement prévu, en cours de fabrication, de nombreuses étapes sélectives de gravure d'un matériau par rapport à un autre ou d'autres, le domaine de la récupération de tranches semiconductrices comportant des défauts, dans lequel, on veut éliminer une couche superficielle pour récupérer un substrat sous-jacent, éventuellement déjà muni d'un certain nombre de couches conformées de façon appropriée, et le domaine de l'amélioration de l'état de surface d'une couche d'un matériau

De façon générale, quand on veut éliminer une couche déposée sur un substrat, de façon sélective par rapport à une autre couche, après avoir éventuellement masqué une partie de la couche à éliminer si on veut n'en éliminer qu'une partie, deux procédés principaux existent dans le domaine de la fabrication des composants semiconducteurs.

La première famille de procédés consiste en une attaque «humide» dans laquelle on immerge la structure dont on veut attaquer une couche dans un produit de gravure, typiquement à base d'acide chlorhydrique ou fluorhydrique. Plusieurs mélanges ont été développés pour permettre une attaque sélective d'une couche par rapport à une autre, par exemple une couche d'oxyde de silicium par rapport à une couche de nitrure de silicium, une couche d'oxyde de silicium par rapport à du silicium, une couche d'un métal par rapport à une couche d'isolant.

Dans cette famille, le document US-A- 6 746 967 décrit un procédé d'oxydation du nickel dans une solution oxydante à PH contrôlé. Simplement pour accélérer l'oxydation, la présence d'ultrasons basse fréquence modifie la barrière énergétique nécessaire l'attaque du nickel par la solution.

La seconde famille de procédés, appelée attaque "sèche", consiste à placer la structure portant la couche à éliminer dans un plasma contenant des agents de gravure, par exemple des espèces chimiques radicalaire ou radicaux actifs de chlore, de fluor, d'oxygène, etc.

La seconde famille de procédés présente de nombreux avantages par rapport à la première, notamment du fait qu'elle permet des attaques anisotropes, et qu'elle présente souvent une meilleure sélectivité de gravure entre deux matériaux. Toutefois, elle présente l'inconvénient de nécessiter des appareillages complexes et, dans le cas où la couche à graver est portée par une tranche de silicium, de ne permettre de traiter qu'une ou deux tranches de silicium à la fois. Par contre, la première famille de procédés, bien que souvent impossible à mettre en oeuvre quand on veut procéder à des attaques fortement sélectives d'un matériau par rapport à un autre matériau, présente l'avantage de permettre des traitements par lots, de nombreuses plaquettes pouvant être disposées dans une nacelle puis immergées dans la solution de gravure.

Diverses variantes de ces deux familles de procédés sont connues de l'homme de métier. Par exemple, en ce qui concerne le procédé de gravure «humide», on propose parfois pour améliorer le résultat d'appliquer un champ électrique entre le matériau à graver et la solution de gravure.

Une troisième famille de procédés, plus généralement utilisée pour le nettoyage, le dégraissage de surfaces, consiste à plonger la surface dans un bain de nettoyage, par exemple de l'alcool, et à appliquer au milieu liquide des vibrations acoustiques à des fréquences acoustiques relativement basses, couramment de l'ordre de 20 à 45 kHz. Alors, les vibrations aident à décoller les particules de salissure de la surface à nettoyer.

Par ailleurs, dans les procédés de gravure «humide», on utilise couramment des mélangeurs pour faire circuler le liquide de gravure sur la surface du matériau à graver et éventuellement des ondes acoustiques basse fréquence, entre 1 à 40 kHz, pour améliorer 1e mélange. Par exemple, dans le document US-A- 4 544 066, 1a solution est agitée par des ultrasons basse fréquence pour uniformiser la réaction sur la surface.

Le document JP 2007 311756 A décrit un procédé de nettoyage de plaques comprenant une solution de nettoyage agitée par des vibrations ultrasoniques. Dans le bac de nettoyage est injecté un gaz, de telle sorte que la limite de solubilité du gaz est dépassée, si bien que des bulles de gaz coexistent dans la solution.

La présente invention a pour objet un procédé de gravure d'une structure incluant au moins un matériau à graver.

Il est proposé un procédé de gravure d'une structure incluant au moins un matériau graver, qui comprend :
- choisir au moins une espèce chimique apte à réagir avec le matériau graver,
- choisir au moins un composé soluble qui ne réagit pas avec ledit matériau mais qui est apte à libérer l'espèce chimique précitée,
- réaliser une solution contenant ledit composé,
- placer la structure dans une position telle que la surface du matériau à graver soit en présence de la solution,
- et produire dans la solution des ultrasons à haute fréquence, à au moins une fréquence, apte à générer des bulles réactives de cavitation, telles que l'espèce chimique est générée et réagit avec le matériau à graver en produisant un composé soluble ou un précipité,
   procédé dans lequel la structure est en outre en présence de bulles additionnelles d'un gaz, différentes des bulles de cavitation, les bulles de cavitation se trouvant en contact et se mélangeant avec les bulles additionnelles de gaz.

Dans le cadre de la présente invention, on entend par « espèce chimique apte à réagir avec le matériau à graver », une espèce chimique atomique et/ou une espèce chimique moléculaire et/ou une espèce chimique ionique et/ou une espèce chimique radicalaire.

L'interface entre la solution et le gaz peut être formée au moins en partie par la surface physique de la solution, au-dessus de laquelle se trouve le gaz, la surface à graver du matériau à graver étant placée en correspondance avec la surface physique de la solution et tournée du côté de la solution.

La surface physique de la solution peut être perturbée ou agitée.

La surface à graver du matériau à graver peut être immergée dans la solution.

Les bulles additionnelles de gaz peuvent être contenues, dispersées ou générées dans la solution.

Les bulles de gaz peuvent résulter de l'injection du gaz dans la solution.

Les bulles additionnelles de gaz peuvent être générées sous l'effet d'un émetteur d'ultrasons à basse fréquence.

Les ultrasons à basse fréquence peuvent avoir une fréquence inférieure à 50 KHz.

La fréquence des ultrasons à haute fréquence peut être au moins dix fois supérieure à la fréquence des ultrasons à basse fréquence.

La fréquence des ultrasons à haute fréquence peut être comprise entre 100 kHz et 3 MHz.

La fréquence des ultrasons à haute fréquence peut être comprise entre 200 kHz et 600 kHz.

Pour la gravure sélective d'une structure comprenant au moins un premier matériau à graver et au moins un second matériau, l'espèce chimique choisie et le composé soluble peuvent ne pas réagir avec le second matériau.

La durée de la production des ultrasons à haute fréquence peut être déterminée pour éliminer le matériau à graver en totalité ou en partie, pour réduire la rugosité de surface du matériau à graver ou pour réduire l'épaisseur du matériau à graver.

La présente invention va maintenant être exposée plus en détail par la description de modes particuliers de réalisation, à titre d'exemples non limitatifs en relation avec des appareillages de gravure représentés schématiquement sur le dessin annexé sur lequel :
- la figure 1 représente une coupe verticale d'un appareillage, une structure à graver étant placée au-dessus d'une solution ;
- la figure 2 représente une coupe verticale d'un appareillage, une structure à graver étant immergée dans une solution ;
- la figure 3 représente une autre structure à graver ; et
- la figure 4 une autre structure à graver immergée dans l'appareillage de la figure 2.

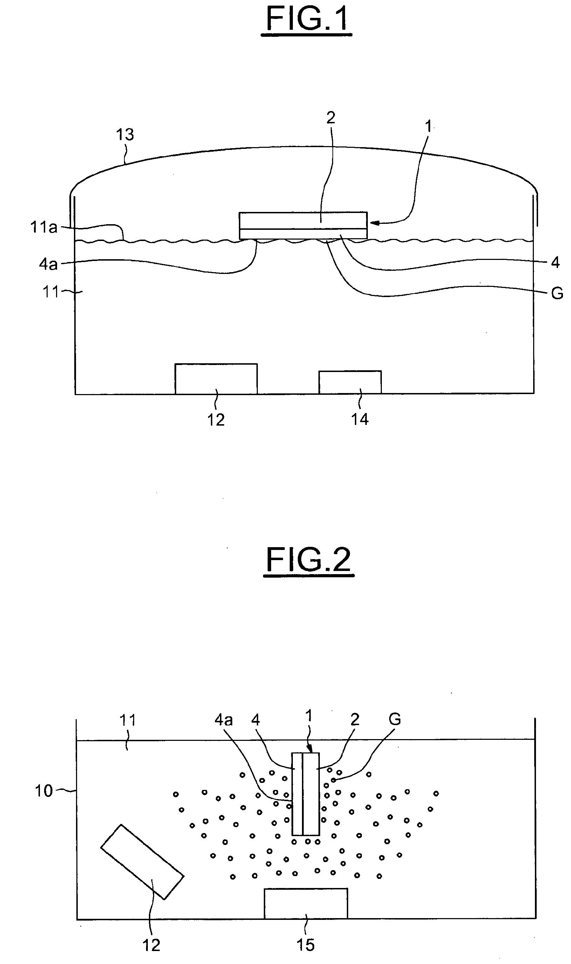

Sur la figure 1, on a représenté un appareillage qui comprend une cuvette ou enceinte 10 qui contient une solution liquide 11 et un émetteur d'ultrasons 12 ou autre source d'ondes acoustiques, au moins en partie introduit dans la solution 11, apte à générer des ondes d'ultrasons à haute fréquence dans cette solution 11, pour produire des bulles réactives de cavitation dans la solution 11.

Une structure 1 incluant, par exemple, une couche 2 sur laquelle est formée une couche 4 en un matériau à graver est placée dans une position telle qu'une surface 4a à graver de cette couche 4 est placée substantiellement en correspondance avec la surface physique 11a de la solution 11, au-dessus de laquelle se trouve un gaz G, la surface 4a étant tournée vers le bas du côté de la solution 1.

Plus précisément, la surface 4a à graver de la couche 4 est placée de telle sorte que, lorsque la surface physique 11a de la solution 11 est stable, il existe un interstice entre cette surface physique 11a et la surface 4a à graver, cet interstice contenant le gaz G.

Selon un exemple, la surface physique 11a de la solution 11 peut être à l'air libre de telle sorte que le gaz G est de l'air.

Selon un autre exemple, la cuvette ou enceinte 10 peut comprendre un couvercle 13 et peut ainsi contenir, au-dessus de la surface physique 11a de la solution 11, un gaz G choisi autre que de l'air.

Lorsque l'émetteur d'ultrasons 12 à haute fréquence est activé, des bulles réactives de cavitation sont générées dans la solution 11, comme on le décrira plus loin, et plus particulièrement dans sa couche surfacique. Ces bulles réactives de cavitation produisent une agitation de la surface physique 11a de la solution 11, de telle sorte que la solution entre en contact avec la surface 4a du matériau à graver 4 et que cette surface à graver 4a est en présence de l'interface entre la solution et le gaz G, ce gaz G prenant la forme de bulles additionnelles différentes des bulles de cavitation. Des bulles additionnelles de gaz peuvent également se trouver introduites dans la couche surfacique de la solution 11.

En complément, un agitateur 14 de la solution 11 pourrait être adjoint pour provoquer une augmentation de l'agitation de la surface physique 11a de la solution 11.

Sur la figure 2, on a représenté un appareillage qui comprend également une cuvette ou enceinte 10 qui contient une solution liquide 11 et un émetteur d'ultrasons 12 ou autre source d'ondes acoustiques, au moins en partie introduit dans la solution 11, apte à générer des ondes d'ultrasons à haute fréquence dans cette solution 11, pour produire des bulles réactives de cavitation dans la solution 11.

Une structure 1 incluant également, par exemple, une couche 2 sur laquelle est formée une couche 4 en un matériau à graver, est au moins partiellement immergée dans la solution 11 dans une position telle qu'une surface 4a à graver de la couche 4 est immergée dans la solution 11, cette surface 4a à graver étant préférentiellement placée verticalement ou de façon inclinée.

Les autres surfaces de la couche 4 et les autres surfaces de la structure ne devant pas être attaquées sont inattaquables ou protégées par exemple par un masque.

L'appareillage de la figure 2 comprend en outre un générateur 15 de bulles de gaz G, différentes des bulles réactives de cavitation.

Selon un exemple, un générateur 15 peut être formé par un émetteur d'ultrasons à basse fréquence, de fréquence inférieure à 50 kHz, générant par cavitation des bulles additionnelles de gaz G dans la solution 11. La fréquence des ultrasons à haute fréquence peut être au moins égale à 10 fois la fréquence des ultrasons à basse fréquence. La durée de vie des bulles additionnelles est notablement plus longue que la durée de vie des bulles réactives de cavitation.

Selon un autre exemple, un générateur 15 peut être formé par un injecteur de bulles additionnelles d'un gaz G choisi.

Dans les cas ci-dessus, les bulles additionnelles de gaz G produites dans la solution 11 présentent un volume nettement supérieur à celui des bulles réactives de cavitation générées, par exemple au moins 100 fois plus grand, voire plusieurs centaines de fois plus grand.

De la sorte, la surface 4a à graver du matériau 4 peut se trouve en présence de bulles additionnelles de gaz G, contre sa surface immergée 4a à graver et à proximité de cette surface.

On va maintenant décrire des exemples relativement à des matériaux à graver et des solutions adaptées pour la gravure de matériaux par rapport à d'autres matériaux à ne pas graver, en mettant en oeuvre l'appareillage de la figure 1 ou celui de la figure 2.

Dans ces exemples, pour des raisons d'écriture, les espèces chimiques aptes à réagir, qui auraient pu être marquées par un « point » sont marquées par un « o » en exposant.

### Exemple 1.

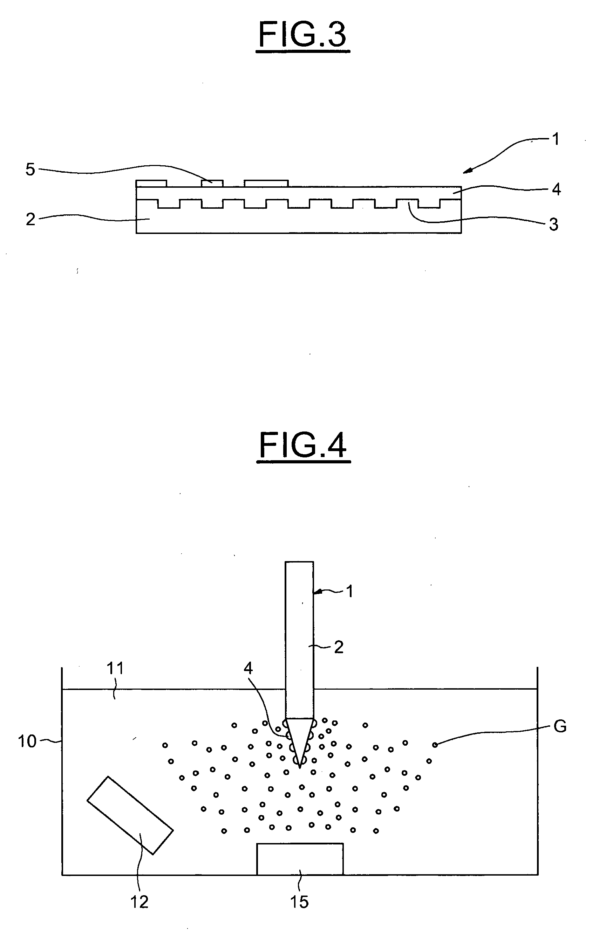

La structure 1, telle que représentée sur la figure 3, peut comprendre une tranche de silicium 2 revêtue d'une couche isolante 3, par exemple une couche d'oxyde de silicium gravée selon un certain motif pour présenter des inégalités d'épaisseur, par exemple en damier, et revêtue d'une couche de cuivre 4. De façon courante, en pratique, une couche intermédiaire d'accrochage, par exemple une couche de nitrure de titane TiN est disposée à l'interface entre la couche d'oxyde 3 et la couche de cuivre 4.

A titre d'exemple d'ordre de grandeur, la tranche de silicium 2 peut présenter une épaisseur de plusieurs centaines de µm et la couche de cuivre 4 peut présenter une épaisseur de l'ordre de 1 µm.

Dans une variante représentée sur la partie droite de la figure 3, on peut chercher à éliminer totalement la couche de cuivre 3, pour récupérer le substrat sous-jacent.

Selon une autre variante représentée sur la partie gauche de la figure 3, on peut chercher à éliminer localement une partie de la couche 4 non protégée par un masque 5 pour réaliser une étape intermédiaire de fabrication d'un dispositif semi-conducteur.

Pour graver la couche de cuivre 4 de la structure 1 dans la solution 11, on peut faire les choix suivants.

On peut choisir une solution 11 contenant des molécules n'attaquant ni le cuivre ni le silicium ni le masque et susceptibles de libérer une espèce chimique apte à réagir avec le cuivre, sans que cette espèce chimique ne réagisse avec le silicium et avec le matériau constituant le masque.

On peut choisir des ondes acoustiques d'ultrasons à haute fréquence aptes à générer des bulles réactives de cavitation, c'est-à-dire des ondes acoustiques ayant une fréquence supérieure à 100 kHz, par exemple comprise entre 100 kHz et 3 MHz, de préférence comprise entre 200 kHz et 3 MHz, et encore de préférence de l'ordre de 200 à 600 kHz. Dans ces plages de fréquences, la taille des bulles réactives de cavitation peut atteindre des valeurs de l'ordre de 1 µm pour des fréquences de l'ordre de 400 kHz et diminue encore jusqu'à des valeurs de l'ordre de 0,1 µm pour des fréquences de l'ordre de 1 MHz.

Selon un exemple particulier, pour attaquer la couche 4 de cuivre, on peut choisir une solution d'HCl à une mole par litre et on peut choisir un émetteur d'ultrasons 12 fournissant des ondes acoustiques à une fréquence de l'ordre de 400 kHz et à une puissance de l'ordre de 300 watts.

Dans ces conditions, des bulles réactives de cavitation à durée d'existence très courte, dans lesquelles les pressions peuvent atteindre des valeurs de l'ordre de plusieurs atmosphères et les températures peuvent avoisiner plusieurs milliers de degrés, sont générées, notamment et plus particulièrement à la surface de la plaquette 1, et engendrent la formation de l'espèce chimique radicalaire Cl° à partir des molécules d'HCl. L'espèce chimique Cl° engendrée réagit avec le cuivre en produisant du CuCl ou du CuCl₂.

La gravure obtenue est bien spécifique au phénomène de création de l'espèce chimique active Cl°. En effet, du cuivre en contact avec une solution d'HCl de même concentration ne réagit pas.

Pour les épaisseurs indiquées ci-dessus, on peut obtenir une élimination complète de la couche 4 de cuivre métallique, totalement ou localement, sans attaque ou gravure de la couche 3 de d'oxyde de silicium, c'est-à-dire sans gravure qui pourrait être supérieure à environ un nanomètre.

### Exemple 2.

Disposant d'une structure 1 incluant une plaquette de silicium 2 portant une couche d'oxyde de silicium 4, on peut chercher à éliminer cette couche d'oxyde de silicium.

Disposant d'une solution 11 de NaOH (soude) à 1 mole par litre et on émet dans cette solution des ondes acoustiques à une fréquence de l'ordre de 400 kHz et à une puissance de l'ordre de 300 watts.

Dans ces conditions, comme dans l'exemple précédent, des bulles réactives de cavitation générées dans la solution, notamment et plus particulièrement à la surface de la plaquette 1, engendrent la formation de l'espèce chimique radicalaire OH°, à partir des molécules NaOH. L'espèce chimique OH° engendrée réagit avec l'oxyde de silicium en produisant du Na₂SiO₄.

La couche d'oxyde de silicium peut être éliminée, sans aucune attaque du silicium sous-jacent.

### Exemple 3.

Disposant d'une plaquette de silicium portant une couche de cuivre comme dans l'exemple I ou une couche d'oxyde de silicium comme dans l'exemple 2, on peut chercher à réduire la rugosité de la surface de cette couche.

Pour cela, on peut mettre en oeuvre par exemple respectivement les conditions de l'exemple 1 ou de l'exemple 2, mais on limite la durée d'action de l'émetteur 12 à ultrasons à haute fréquence à une durée telle que seule la matière constituant les rugosités ou aspérités est attaquée au moins partiellement.

L'attaque des rugosités est d'autant plus efficace que la densité des bulles de cavitation est plus importante à l'extrémité de ces rugosités ou aspérités.

### Exemple 4.

Disposant d'une plaquette 1 présentant une couche de cuivre comme dans l'exemple 1 ou une couche d'oxyde de silicium comme dans l'exemple 2, on peut chercher à réduire l'épaisseur de cette couche.

Pour cela, on peut mettre en oeuvre par exemple les conditions de l'exemple I ou de l'exemple II, mais on limite et on contrôle la durée d'action de l'émetteur 12 à ultrasons à haute fréquence, de telle sorte que l'épaisseur restante de la couche atteigne une valeur souhaitée.

Considérant les exemples qui précèdent, on va maintenant décrire de façon plus particulière la gravure sélective d'un premier matériau 4 par rapport à un second matériau 2, d'une structure 1, en prenant les dispositions suivantes.

On choisit une espèce chimique apte à réagir avec le premier matériau à graver et à ne pas réagir avec le second matériau.

On choisit un composé soluble qui n'attaque pas ces matériaux et apte à libérer l'espèce chimique sélectionnée.

Ayant réalisé une solution contenant ce composé et ayant immergé la structure dans la solution, on produit dans la solution des ultrasons à une fréquence apte à générer des bulles de cavitation.

Il en résulte que les bulles réactives de cavitation, dans lesquelles les pressions atteignent des valeurs de l'ordre de plusieurs atmosphères et la température avoisine plusieurs milliers de degrés, engendrent la production, dans la solution et notamment au voisinage de la surface solide à traiter, de l'espèce chimique choisie, qui réagit sélectivement avec le premier matériau en produisant un composé soluble ou un précipité, sans attaquer le second matériau.

Pour effectuer le choix de l'espèce chimique adaptée et du composé soluble adapté, l'homme de l'art saura utiliser par exemple le logiciel "facstage" contenant la base de données européenne SGTE pour déterminer une espèce chimique susceptible de réagir avec un premier matériau pour produire un composé soluble ou facilement effritable ou un précipité, cette espèce chimique ne réagissant pas avec un second matériau.

La base de données SGTE n'est pas la seule base de données thermodynamique à la disposition de l'homme de l'art. D'autres bases existent telles que par exemple le logiciel "thermocalc". Pour avoir accès au logiciel "thermocalc" ou au logiciel "factsage", il suffit de se connecter sur les sites Internet suivants : http://www.thermocalc.com ; www.factsage.com ; www.gtt-technologies.com

Ces bases servent de support à des logiciels qui, par minimisation d'énergie de Gibbs, sont capables de donner les composés thermodynamiquement stables qui se formeront par réaction chimique à partir d'un mélange de départ donné. Par thermodynamiquement stable, on entend un produit qui serait obtenu après un temps de réaction infini. On peut par exemple observer ce qui suit.
- un mélange de départ silice + cuivre solide + HCl dilué à 1 Mole par litre n'évolue pas (reste stable). Si on ajoute dans le calcul qu'il existe en solution des espèces chimiques radicalaires ou radicaux C1°, le cuivre solide se transformera totalement en CuCl₂ et Cu²⁺ mais la silice n'évoluera pas.
- un mélange de départ de silicium + silice et de soude à 1 mole par litre est un mélange thermodynamiquement stable (pas d'évolution). Si l'on ajoute au calcul que l'on va former en solution les espèces chimiques radicalaire OH° ou Na°, le logiciel de thermodynamique montre que la silice sera transformée en composé H₄SiO₄ solide alors que le silicium restera stable.

L'homme de l'art saura déterminer quelles espèces chimiques peuvent se former dans une solution donnée et tester, en utilisant les logiciels susmentionnés, quelles phases (composés ou corps purs) seront stables en solution et lesquelles évolueront par réaction chimique.

On peut noter les exemples suivants, pour le choix d'une espèce chimique destinée à graver un premier matériau sans attaquer un second matériau d'une plaquette.

L'espèce chimique OH° peut être active pour attaquer ou graver Si, sans attaquer SiGe.

L'espèce chimique H° peut être active pour graver InSnO₃, sans attaquer SiO₂.

L'espèce chimique Cl° peut être active pour attaquer ou graver Cu, sans attaquer SiO₂.

L'espèce chimique F° peut être active pour attaquer ou graver Si, sans attaquer un polymère.

L'espèce chimique Cl° peut être active pour attaquer ou graver Au, sans attaquer une céramique AIN.

L'espèce chimique OH° ou l'espèce chimique Cl° peuvent être actives pour attaquer ou graver Al, sans attaquer Al₂O₃.

L'espèce chimique OH° peut être active pour attaquer ou graver W, sans attaquer Al₂O₃.

L'espèce chimique Cl° peut être active pour attaquer ou graver Cu, sans attaquer SiO₂ ou une céramique TiN.

L'espèce chimique H° ou l'espèce chimique Cl° peuvent être actives pour attaquer ou graver InSnO₂, sans attaquer un polymère ou un verre.

L'espèce chimique Na° ou l'espèce chimique F° peuvent être actives pour attaquer ou graver SiO₂, sans attaquer Al.

L'espèce chimique H° ou l'espèce chimique F° peuvent être actives pour attaquer ou graver Al₂O₃, sans attaquer W.

L'espèce chimique Br° peut être active pour attaquer ou graver TiN, sans attaquer SiO₂.

L'espèce chimique K° peut être active pour attaquer ou graver Si₃N₄, sans attaquer SiO ou un polymère.

L'espèce chimique Cl° peut être active pour attaquer ou graver une céramique TaN, sans attaquer SiO₂.

Par ailleurs, l'homme de l'art saura, par des essais simples, déterminer dans chaque cas particulier la concentration de la solution choisie, la fréquence optimale et la puissance optimale des ultrasons pour que l'effet des bulles de cavitation produites engendre l'attaque souhaitée, ainsi que la durée du traitement à appliquer au premier matériau à graver.

On peut noter la grande simplicité du procédé de mise en oeuvre, et le fait que l'on peut traiter simultanément, dans une même solution, un lot de structures 1.

Dans un autre exemple représenté sur la figure 4, il est proposé de réaliser le nettoyage de l'extrémité de pointes 2 de contact électrique salie par un dépôt de particules 4 à enlever, en particulier l'attaque chimique de particules d'aluminium déposées ou accrochées sur des pointes en tungstène utilisées pour effectuer le test de puces électroniques, les extrémités salies des pointes 2 étant plongées dans une solution 11 de l'appareillage de la figure 2. Dans ce cas, on peut choisir une solution de NaCl, qui n'attaque ni l'aluminium ni le tungstène mais qui pourra libérer des espèces chimiques Cl° pour attaquer l'aluminium sans attaquer le tungstène.

Dans l'ensemble des exemples de gravure qui viennent d'être décrits, on va maintenant décrire les effets des bulles additionnelles de gaz G mentionnées plus haut.

Les bulles additionnelles de gaz G se trouvent en présence des bulles de cavitation. Des bulles de cavitation se trouvent en contact avec les bulles additionnelles de gaz G et se mélangent aux bulles additionnelles de gaz G. Les bulles additionnelles du gaz G ont une durée de vie nettement supérieure à celle des bulles actives de cavitation.

Les bulles additionnelles de gaz G ont pour effet principal d'accroître notablement la vitesse d'attaque du matériau à graver, ceci notamment pour les raisons suivantes.

L'effet principal est d'augmenter la surface de contact entre les bulles de gaz et la solution. Sachant que, dans cette zone d'interface, les échanges ou transferts d'espèces chimiques entre le gaz additionnel G et la solution sont augmentés, les espèces chimiques créées dans les bulles de cavitation sont plus nombreuses pour l'attaque du matériau à attaquer.

Le gaz additionnel participe à la réaction chimiquement et/ou en modifiant des paramètres chimiques de réaction.

Le gaz G choisi peut participer à l'attaque en apportant un composé chimique adapté. Par exemple, l'oxygène de l'air choisi comme gaz G peut contribuer fortement à l'attaque du silicium (Si), l'aluminium (A1), le tungstène (W). Dans d'autres exemples, le chlorure d'hydrogène (HCl) choisi comme gaz G peut contribuer fortement à l'attaque du cuivre (Cu), de l'aluminium (Al).

Dans le cas où le gaz G choisi contient de l'argon (Ar) qui peut être apte à modifier des paramètres chimiques de réaction, les bulles actives de cavitation deviennent beaucoup plus énergétiques.

## Revendications

1. Procédé de gravure d'une structure (1) comprenant au moins un matériau à graver (4), comprenant :
- choisir au moins une espèce chimique apte à réagir avec le matériau à graver (4),
- choisir au moins un composé soluble qui ne réagit pas avec ledit matériau mais qui est apte à libérer l'espèce chimique précitée,
- réaliser une solution (11) contenant ledit composé,
- placer la structure (1) dans une position telle que la surface du matériau à graver soit en présence de la solution,
- et produire dans la solution des ultrasons à haute fréquence, à au moins une fréquence, apte à générer des bulles réactives de cavitation, telles que l'espèce chimique est générée et réagit avec le matériau à graver en produisant un composé soluble ou un précipité,
procédé dans lequel la structure est en outre en présence de bulles additionnelles d'un gaz (G), différentes des bulles de cavitation, les bulles de cavitation se trouvant en contact et se mélangeant avec les bulles additionnelles de gaz (G).

2. Procédé selon la revendication 1, dans lequel l'interface entre la solution et le gaz est formée au moins en partie par la surface physique de la solution, au-dessus de laquelle se trouve le gaz, et dans lequel la surface à graver du matériau à graver est placée en correspondance avec la surface physique de la solution et tournée du côté de la solution.

3. Procédé selon la revendication 2, dans lequel la surface physique de la solution est perturbée ou agitée.

4. Procédé selon la revendication 1, dans lequel la surface à graver du matériau à graver est immergée dans la solution.

5. Procédé selon l'une quelconque des revendications précédentes, dans lequel les bulles additionnelles de gaz sont contenues, dispersées ou générées dans la solution.

6. Procédé selon l'une quelconque des revendications précédentes, dans lequel les bulles de gaz résultent de l'injection du gaz dans la solution.

7. Procédé selon l'une quelconque des revendications précédentes, dans lequel les bulles additionnelles de gaz sont générées sous l'effet d'un émetteur d'ultrasons à basse fréquence.

8. Procédé selon la revendication 7, dans lequel les ultrasons à basse fréquence ont une fréquence inférieure à 50 KHz.

9. Procédé selon la revendication 7, dans lequel la fréquence des ultrasons à haute fréquence est au moins dix fois supérieure à la fréquence des ultrasons à basse fréquence.

10. Procédé selon l'une quelconque des revendications précédentes, dans lequel la fréquence des ultrasons à haute fréquence est comprise entre 100 kHz et 3 MHz.

11. Procédé selon l'une quelconque des revendications précédentes, dans lequel la fréquence des ultrasons à haute fréquence est comprise entre 200 kHz et 600 kHz.

12. Procédé selon l'une quelconque des revendications précédentes, pour la gravure sélective, d'une structure (1) comprenant au moins un premier matériau à graver (4) et au moins un second matériau (2), dans lequel l'espèce chimique choisie et le composé soluble ne réagissent pas avec le second matériau (3).

13. Procédé selon l'une quelconque des revendications précédentes, dans lequel la durée de la production des ultrasons à haute fréquence est déterminée pour éliminer le matériau à graver en totalité ou en partie, pour réduire la rugosité de surface du matériau à graver ou pour réduire l'épaisseur du matériau à graver.

## Patentansprüche

1. Verfahren zum Ätzen einer mindestens ein zu ätzendes Material (4) enthaltenden Struktur (1), das enthält:
- Wahl mindestens einer chemischen Spezies, die mit dem zu ätzenden Material (4) reagieren kann,
- Wahl mindestens einer löslichen Verbindung, die nicht mit dem Material reagiert, aber die erwähnte chemische Spezies freisetzen kann,
- Herstellen einer Lösung (11), die die Verbindung enthält,
- Anordnen der Struktur (1) in einer solchen Stellung, dass die Fläche des zu ätzenden Materials in Gegenwart der Lösung ist,
- und Erzeugen von hochfrequenten Ultraschallwellen in der Lösung, mit mindestens einer Frequenz, die reaktive Kavitationsblasen erzeugen kann, derart, dass die chemische Spezies erzeugt wird und mit dem zu ätzenden Material reagiert, indem eine lösliche Verbindung oder eine Ausfällung erzeugt wird,
Verfahren, bei dem die Struktur außerdem in Gegenwart zusätzlicher Blasen eines Gases (G) ist, die sich von den Kavitationsblasen unterscheiden, wobei die Kavitationsblasen sich mit den zusätzlichen Gasblasen (G) in Kontakt befinden und damit vermischen.

2. Verfahren nach Anspruch 1, wobei die Schnittstelle zwischen der Lösung und dem Gas zumindest zum Teil von der physikalischen Fläche der Lösung gebildet wird, oberhalb der sich das Gas befindet, und wobei die zu ätzende Fläche des zu ätzenden Materials entsprechend der physikalischen Fläche der Lösung platziert wird und zur Seite der Lösung weist.

3. Verfahren nach Anspruch 2, wobei die physikalische Fläche der Lösung gestört oder bewegt wird.

4. Verfahren nach Anspruch 1, wobei die zu ätzende Fläche des zu ätzenden Materials in die Lösung eingetaucht wird.

5. Verfahren nach einem der vorhergehenden Ansprüche, wobei die zusätzlichen Gasblasen in der Lösung enthalten sind, verteilt sind, oder darin erzeugt werden.

6. Verfahren nach einem der vorhergehenden Ansprüche, wobei die Gasblasen aus der Injektion des Gases in die Lösung resultieren.

7. Verfahren nach einem der vorhergehenden Ansprüche, wobei die zusätzlichen Gasblasen unter der Wirkung eines Emitters niederfrequenter Ultraschallwellen erzeugt werden.

8. Verfahren nach Anspruch 7, wobei die niederfrequenten Ultraschallwellen eine Frequenz von weniger als 50 kHz haben.

9. Verfahren nach Anspruch 7, wobei die Frequenz der hochfrequenten Ultraschallwellen mindestens zehn Mal höher ist als die Frequenz der niederfrequenten Ultraschallwellen.

10. Verfahren nach einem der vorhergehenden Ansprüche, wobei die Frequenz der hochfrequenten Ultraschallwellen zwischen 100 kHz und 3 MHz liegt.

11. Verfahren nach einem der vorhergehenden Ansprüche, wobei die Frequenz der hochfrequenten Ultraschallwellen zwischen 200 kHz und 600 kHz liegt.

12. Verfahren nach einem der vorhergehenden Ansprüche für das selektive Ätzen einer Struktur (1), die mindestens ein erstes zu ätzendes Material (4) und mindestens ein zweites Material (2) enthält, wobei die gewählte chemische Spezies und die lösliche Verbindung nicht mit dem zweiten Material (3) reagieren.

13. Verfahren nach einem der vorhergehenden Ansprüche, wobei die Dauer der Erzeugung der hochfrequenten Ultraschallwellen bestimmt wird, um das zu ätzende Material ganz oder teilweise zu entfernen, um die Flächenrauigkeit des zu ätzenden Materials zu reduzieren oder um die Dicke des zu ätzenden Materials zu reduzieren.

## Claims

1. Method for etching a structure (1) comprising at least one material to be etched (4), comprising:
- choosing at least one chemical species capable of reacting with the material to be etched (4);
- choosing at least one soluble compound that does not react with said material but which is able to release the aforementioned chemical species;
- producing a solution (11) containing said compound;
- placing the structure (1) in a position such that the surface of the material to be etched is in the presence of the solution; and
- producing high-frequency ultrasound in the solution with at least one frequency capable of generating reactive cavitation bubbles, in the presence of said additional bubbles, such that the chemical species is generated and reacts with the material to be etched, while producing a soluble compound or a precipitate,
in which method the structure is also in the presence of additional bubbles of a gas (G), different from the cavitation bubbles, the cavitation bubbles being found in contact with and mixing with the additional bubbles of gas (G).

2. Method according to Claim 1, in which the interface between the solution and the gas is formed at least partially by the physical surface of the solution, above which occurs the gas, and in which the surface to be etched of the material to be etched is placed in touch with the physical surface of the solution and turned in the direction of the solution.

3. Method according to Claim 2, in which the physical surface of a solution is perturbed or agitated.

4. Method according to Claim 1, in which the surface to be etched of the material to be etched is immersed in the solution.

5. Method according to any one of the preceding claims, in which the additional gas bubbles are contained, dispersed or generated in the solution.

6. Method according to any one of the preceding claims, in which the gas bubbles result from the injection of the gas into the solution.

7. Method according to any one of the preceding claims, in which the additional gas bubbles are generated under the effect of a low-frequency ultrasound emitter.

8. Method according to Claim 7, in which the low-frequency ultrasound has a frequency of less than 50 kHz.

9. Method according to Claim 7, in which the frequency of the high-frequency ultrasound is at least ten times greater than the frequency of the low-frequency ultrasound.

10. Method according to any one of the preceding claims, in which the high-frequency ultrasound frequency lies between 100 kHz and 3 MHz.

11. Method according to any one of the preceding claims, in which the high-frequency ultrasound frequency lies between 200 kHz and 600 kHz.

12. Method according to any one of the preceding claims, for the selective etching of a structure (1) comprising at least one first material to be etched (4) and at least one second material (2), in which the chosen chemical species and the soluble compound do not react with the second material (3).

13. Method according to any one of the preceding claims, in which the period during which high-frequency ultrasound is produced is determined in order totally or partially to remove the material to be etched, in order to reduce the surface roughness of the material to be etched or in order to reduce the thickness of the material to be etched.
